# EUROPÄISCHE PATENTANMELDUNG

(11) **EP 4 509 635 A1**
(43) Veröffentlichungstag der Anmeldung: **19.02.2025**
(21) Anmeldenummer: 23192187.5
(22) Anmeldetag: 18.08.2023
(51) Int. Cl.: C23C 14/22, B01D 67/00, C23C 24/04

(54) **HERSTELLEN VON SCHICHTKÖRPERN AUS LISICON-MATERIAL**

(71) Anmelder: Evonik Operations GmbH, 45128 Essen (DE)
(72) Erfinder: HYING, Christian, 46414 Rhede (DE); GORMAN, Elisabeth, 45721 Haltern am See (DE); STENNER, Patrick, 63452 Hanau (DE); STADTMÜLLER, Tobias, 63500 Seligenstadt (DE); ARNDT, Sebastian, 65462 Ginsheim Gustavsburg (DE); LÖFFLER, Frank, 64646 Heppenheim (DE); SCHMIDT, Franz, 64521 Groß- Gerau (DE)
(74) Vertreter: Evonik Patent Association

(57) **Zusammenfassung**

Die Erfindung befasst sich mit Schichtkörpern aus LiSICon-Material, deren Herstellung und Verwendung. Ihr lag die Aufgabe zu Grunde, eine Membran für die Abscheidung von Lithium aus verunreinigten lithiumhaltigen Wässern anzugeben, die vergleichsweise preiswert ist und eine gute Permeanz für Lithium im Elektrodialysebetrieb erlaubt. Gelöst wird diese Aufgabe dadurch, dass ein Substrat mit einem LiSICon-Material beschichtet wird, und zwar im Wege der aerosolbasierten Kaltabscheidung. Auf diese Weise wird nämlich ein Schichtkörper erhalten, der sich aufgrund seiner besonderen Materialkombination hervorragend als Membran zur elektrodialytischen Lithiumabscheidung eignet.

## Beschreibung

Die Erfindung befasst sich mit Schichtkörpern aus LiSICon-Material, deren Herstellung und Verwendung.

Schichtkörper sind feste Gegenstände, die eine Mehrzahl von unterschiedlichen Materialien enthalten. Außerdem ist ein Schichtkörper schichtartig aufgebaut, er umfasst also eine Mehrzahl von übereinander angeordneten Schichten. Jeder Schicht ist mindestens ein Material zugeordnet, welches sich in der jeweiligen Schicht findet. Im einfachsten Fall ist jeder Schicht genau ein Material zugeordnet, sodass die Anzahl der Schichten der Anzahl der Materialien entspricht. Selbstverständlich können einer Schicht auch mehrere Materialien zugeordnet sein. In der Praxis sind die einzelnen Materialien jedoch in dem gesamten Schichtkörper verteilt; freilich mit einer statistischen Häufung innerhalb der zugeordneten Schichten. Folglich sind die der jeweiligen Schicht zugeordnete Materialien in der Schicht lediglich angereichert. Insbesondere in dem Grenzbereich zwischen zwei aufeinanderliegenden Schichten kommen die den benachbarten Schichten zugeordnete Materialien nebeneinander vor.

Schichtkörper können die unterschiedlichsten geometrischen Gestalten annehmen. Im einfachsten Fall weist ein Schichtkörper eine im Wesentlichen flache Gestalt auf, mit einer Mehrzahl von ebenfalls flachen, übereinander angeordneten Schichten. In der Regel ist die Stärke des Schichtkörpers und die einzelner Schichtstärken wesentlich kleiner als die Längs- und Quererstreckung des Schichtkörpers, sodass dieser - unter Vernachlässigung der Stärke - im Wesentlichen zweidimensional erscheint. Selbstverständlich können Schichtkörper auch kompliziertere Gestalten aufweisen. Insbesondere die Stärke der einzelnen Schichten kann unterschiedlich sein.

Schichtkörper werden in der Regel dadurch hergestellt, dass ein Substrat mit mindestens einer Schicht beschichtet wird. Der Schichtkörper setzt sich dann aus mindestens zwei Schichten zusammen, nämlich einer ersten Schicht, die von dem Substrat gebildet wird und der Beschichtung als zweite Schicht. Der Schichtkörper umfasst dann das Substratmaterial und das Besch ichtu ngsmaterial.

Die Erfindung beschäftigt sich konkret mit solchen Schichtkörpern, die zumindest teilweise aus LiSICon-Materialien aufgebaut sind, nämlich LiSICon als Substratmaterial und/oder als Beschichtungsmaterial.

LiSICon steht für Lithium Super lonic Conductor. Es handelt sich dabei um eine Klasse aus anorganischem, (glas)keramischen Material, welches elektrisch isoliert, aber zugleich eine intrinsische Leitfähigkeit für Li-Ionen aufweist. Der Begriff LiSICon wurde vor einigen Jahren lediglich für wenige Materialien mit einer bestimmten Stöchiometrie und Kristallstruktur verwendet. Nachdem aber immer mehr Materialen mit ähnlichen Eigenschaften entdeckt oder entwickelt wurden, wird der Begriff LiSICon heute eher generisch für (Glas-)Keramiken mit intrinsischer Li-Leitfähigkeit verwendet. Der Transportmechanismus für Lithium ist in der Kristallstruktur dieses Materials begründet. Die Li-Ionen werden - vereinfacht gesprochen - durch die Kristalle "durchgereicht". Kommerziell verfügbare LiSICon-Materialien sind unter anderem Lithium-Aluminium-Titanphosphat (LATP), Lithium-Aluminium-Titan-Siliciumphosphat (LATSP), Lithium-Aluminium-Germaniumphosphat (LAGP) und Lithium-Lanthan-Titanoxid (LLTO). Eine allgemeine Einführung in LiSICon Materialen und deren Transportmechanismus bieten:
Palakkathodi Kammampata et al.: Cruising in ceramics-discovering new structures for all-solid-state batteries-fundamentals, materials, and performances. Ionics 24, 639-660 (2018) DOI: 10.1007/s11581-017-2372-7
Yedukondalu Meesala et al.: Recent Advancements in Li-lon Conductors for All-Solid-State Li-Ion Batteries. ACS Energy Lett. 2017, 2, 12, 2734-2751 DOI: 10.1021/acsenergylett.7b00849

Wie in diesen beiden Übersichtsartikeln geschildert, lassen sich LiSICons als Festkörper-Elektrolyt für Lithiumionenbatterien (LIB) einsetzen.

Aufgrund ihrer selektiven Leitfähigkeit für Li-Ionen können LiSICon-Materialien auch als Membran zur elektrodialytischen Abtrennung von Lithium aus Li-haltigen Wässern verwendet werden. Das Lithium muss in dem Gemisch in ionischer Form vorliegen, etwa als in Wasser gelöstes Li-Salz.

Unter anderem aus der WO 2022157624 A1 ist ein Verfahren zur elektrodialytischen Abtrennung von Lithium aus Meerwasser bekannt. Darin wird eine LiSICon-Membran aus LLTO verwendet. Da Meerwasser Lithium lediglich in geringen Mengen enthält, müssen die Membranen entsprechend großflächig ausgeführt werden, um Li wirtschaftlich aus dem Meer gewinnen zu können. Dies erscheint mit vergleichsweise preiswerten LLTO möglich.

Allerdings ist auch zu berücksichtigen, dass LLTO verglichen mit anderen LiSICons eine geringere spezifische Leitfähigkeit für Li besitzt. Bei gegebener Materialstärke wirkt sich eine geringe intrinsische Li-Leitfähigkeit des Membranmaterials auf eine geringe Permeanz der Membran aus. Die Permeanz ist ein Maß für die Leitfähigkeit der Membran unter Berücksichtigung ihrer Stärke. Je höher die Permeanz der Membran, desto geringer ist der Bedarf an elektrischer Energie für den Dialyseprozess. LiSICon-Materialien mit geringer intrinsischer Li-Leitfähigkeit reduzieren daher die Permeanz der Membran und steigern den Energiebedarf des Prozesses. Zwar ist es theoretisch möglich, die Materialstärke der Membran zu reduzieren und dadurch ihre Permeanz wieder zu steigern. Allerdings kann die Stärke des Membranmaterials aus Stabilitätsgründen eine gewisse Mindeststärke nicht unterschreiten. Deswegen lässt sich die geringe spezifische Leitfähigkeit des LLTO in Praxis nicht einfach durch eine geringe Membranstärke ausgleichen. Das gilt umso mehr, wenn die Membran im Betrieb Verschleiß ausgesetzt ist.

Im Ergebnis erreicht eine LLTO-Membran stets eine geringere Permeanz als eine Membran aus einem LiSICon mit höherer intrinsischer Li-Leitfähigkeit. Sie erfordert daher mehr Energie für den Betrieb der Elektrodialyse.

Die Gewinnung von Lithium aus dem Meer mit einer LLTO Membran erscheint deswegen vor allem dann attraktiv, wenn gleichzeitig preiswerte elektrische Energie zur Verfügung steht - insbesondere aus erneuerbaren Quellen.

Als alternative Lithiumquelle zu Meerwasser lassen sich natürliche Li-Solen oder lithiumhaltige Wässer verwenden, die bei Herstellung von frischen LIB als Produktionsabfall oder beim Recycling gebrauchter LIB anfallen. Anders als Meerwasser enthalten solche lithiumhaltige Wässer zwar das begehrte Lithium in vergleichsweise hohen Konzentration, jedoch auch störende Verunreinigungen wie insbesondere Kationen von folgenden Elementen: B, Na, Mg, Al, Si, K, Ca, Mn, Fe, Co, Ni, Cu, C. Die Alkali- und Erdalkalimetalle kommen insbesondere in lithiumhaltigen Solen natürlichen Ursprungs vor, währenddessen die anderen Metallkationen sich insbesondere in lithiumhaltigen Wässern finden, die aus der Aufarbeitung von verbrauchten LIB oder aus Produktionsabfällen der LIB-Herstellung stammen. Solche Ströme enthalten auch oft Kohlenstoffverbindungen, die aus Klebern, Bindern, den Anodenmaterialien der LIB, aus Rußen oder der Kunststoff-Verpackungen der LIB stammen. Diese können dann kohlenstoffhaltige Säuren, oder die Kationen dieser aber auch ungeladene organische Zersetzungsprodukte aus den vorgelagerten Schritten des LIB-Recycling enthalten.

Leider sind die momentan kommerziell verfügbaren LiSICon-Materialien auf "Phosphat-Basis" wie z.B. LAGTP, LATSP oder LAGP recht empfindlich gegen die vorerwähnten Verunreinigungen: Insbesondere Natrium-, Kalium-, Kalzium- und Magnesium-Ionen reduzieren die Lithium-Leitfähigkeit der Phosphat-basierten LiSICons, sobald sie mit dem Material in Kontakt kommen. Teilweise werden LAGTP- LATSP oder LAGP-Membranen durch diese Ionen direkt zerstört. Deswegen können Lithiumhaltige Wässer, die viele kationische Verunreinigungen enthalten, nicht ohne aufwändige Vorreinigung mit Phosphat-basierten LiSICon-Membranen in Kontakt gebracht werden (vgl. etwa US20120103826A1). Insbesondere die Rückgewinnung von Lithium aus den stark verunreinigten Abfallströmen der LIB-Herstellung oder des LIB-Recyclings wird durch diese Vorreinigungsmaßnahmen rasch unwirtschaftlich.

Es besteht zwar die Möglichkeit, anstelle des empfindlichen, Phosphat-basierten LiSICon das LLTO zur Abtrennung von Li aus Wässern mit einem hohem Anteil von kationischen Verunreinigungen zu nutzen. Allerdings hat LLTO verglichen mit den Phosphat-basierten LiSICons wie LAGTP, LATSP oder LAGP eine deutlich geringere spezifische Li-Leitfähigkeit, welche wiederum den Energiebedarf der Elektrodialyse erhöht.

Die Auswahl des trennaktiven Membranmaterials für die Elektrodialyse von Lithium wird weiter dadurch verkompliziert, dass nicht alle im Labor herstellbaren LiSICons auch im industriellen Maßstab verfügbar sind und dass die Preise für diese Materialien teilweise sehr hoch sind.

Aus all diesen Gründen ist es nicht trivial, ein LiSICon-Material zu identifizieren, welches für die Abtrennung von Li aus verunreinigten Wässern einen guten Kompromiss aus Anschaffungskosten, Standzeit und Li-Leitfähigkeit bietet.

Auch die WO 2019055730 A1 beschäftigt sich mit der Abtrennung von Lithium aus wässrigen Lösungen mit Hilfe von LiSICon-Membranen. Konkret werden LLTO oder LAGP oder LATP genannt. Das LiSICon-Material kann auf eine poröse Stützstruktur aufgetragen sein. Auf die chemische Natur dieser Stützstruktur geht die WO 2019055730 A1 allerdings mit keinem Wort ein. Ebenso verschweigt diese Schrift, wie das Auftragen von LiSICon auf die Stützstruktur geschehen soll.

In Hinblick auf diesen Stand der Technik war es die Aufgabe, eine Membran für die Abscheidung von Lithium aus verunreinigten lithiumhaltigen Wässern anzugeben, die vergleichsweise preiswert ist und eine gute Permeanz für Lithium im Elektrodialysebetrieb erlaubt.

Gelöst wird diese Aufgabe dadurch, dass ein Substrat mit einem LiSICon-Material beschichtet wird, und zwar im Wege der aerosolbasierten Kaltabscheidung. Auf diese Weise wird nämlich ein Schichtkörper erhalten, der sich aufgrund seiner besonderen Materialkombination hervorragend als Membran zur elektrodialytischen Lithiumabscheidung eignet. Zwar war die Verwendung von Schichtkörpern als Membran zur Lithiumabscheidung schon vorskizziert, aber es war keine konkrete Technologie angegeben, mit der sich eine Membran mit der besonderen Materialzusammensetzung herstellen ließe.

Gegenstand der Erfindung ist mithin ein Verfahren zur Herstellung eines Schichtkörpers mit den folgenden, nicht chronologischen Schritten:
a) Bereitstellen eines Substrats enthaltend mindestens ein Substratmaterial, wobei das Substratmaterial ausgewählt ist aus der Gruppe bestehend aus den folgenden Materialien:
   - metallischer Werkstoff M;
   - keramischer Werkstoff K;
   - glasartiger Werkstoff G;
   - polymerer Werkstoff P;
   - LiSICon mit der Stöchiometrie LATSP

      Li_{1+x+y}AlₓTi₂₋ₓSi_{y}P_{3-y}O₁₂ (LATSP)

      worin in LATSP gilt: 0.1≤x≤0.3 und 0.2≤y≤0.4;
   - LiSICon mit der Stöchiometrie LAGTP

      Li_{1.4}Al_{0.4}(Ge₁₋ₓTiₓ)_{1.6}(PO₄)₃ (LAGTP)

      worin in LAGTP gilt: 0≤x≤1;
b) Bereitstellen eines ersten anorganischen Materials in Pulverform, wobei das erste anorganische Material ausgewählt ist aus der Gruppe bestehend aus den folgenden Materialien:
   ∘ LiSICon mit der Stöchiometrie LAGTP

      Li_{1.4}Al_{0.4}(Ge₁₋ₓTiₓ)_{1.6} (PO₄)₃ (LAGTP)

      worin in LAGTP gilt: 0≤x≤1
   ∘ LiSICon mit der Stöchiometrie LAGP

      Li₁₊ₓAlₓGe₂₋ₓ (PO₄)₃ (LAGP)

      worin in LAGP gilt: x=0 oder x=0.2 oder x=0.4.
   ∘ LiSICon mit der Stöchiometrie LATSP

      Li_{1+x+y}AlₓTi₂₋ₓSi_{y}P_{3-y}O₁₂ (LATSP)

      worin in LATSP gilt: 0.1≤x≤0.3 und 0.2≤y≤0.4;
   ∘ LiSICon mit der Stöchiometrie LLTO

      Li₃ₓLa_{(2/3)-x□(1/3)-2x}TiO₃ (LLTO)

      worin in LLTO gilt: 0≤x≤0.16 und wobei das LLTO optional dotiert sein kann mit mindestens einem Dotierelement, welches ausgewählt ist aus der Gruppe bestehend aus den folgenden Dotierelementen: Ag, Al, Zr, Nd, Sr, Ta, Y, Ge, Nb;
   ∘ LiSICon mit der Stöchiometrie LLZO

      Li₇La₃ (Zr, D)₂O₁₂ (LLZO)

      worin in LLZO die Dotiersubstanz D ausgewählt aus der Gruppe bestehend aus den folgenden Dotiersubstanzen: Hf, Ce, Ru;
c) Bereitstellen eines Trägergases;
d) Dispergieren des ersten anorganischen Materials in dem Trägergas, sodass ein Aerosolstrom erhalten wird,
e) Platzieren des Substrats in einem evakuierten Raum, in welchem ein Absolutdruck von 0.1 kPa bis 1 kPa und eine Temperatur von 15°C bis 25°C herrschen;
f) Beaufschlagen des in dem evakuierten Raum platzierten Substrats mit dem Aerosolstrom, sodass zumindest eine Schicht enthaltend das erste anorganische Material auf dem Substrat abgeschieden wird;
g) Erhalt eines Schichtkörpers umfassend das Substrat und mindestens die vorerwähnte Schicht, in welcher das erste anorganische Material angereichert ist, wobei die vorerwähnte Schicht auf dem Substrat abgeschieden ist.

Das erfindungsgemäße Verfahren arbeitet nach dem Prinzip der aerosolbasierten Kaltabscheidung. Es ermöglicht die Beschichtung eines Substrats aus Metall, Keramik, Glas oder Polymer mit LiSICon-Materialien. Insbesondere erlaubt das hier beschriebene Verfahren einen Schichtkörper herzustellen, der aus zwei unterschiedlichen LiSICon-Materialien aufgebaut ist: Dies erfolgt durch Beschichten eines Substrat aus einem ersten LiSICon-Material mit einem zweiten LiSICon-Material. Ebenso erlaubt das Verfahren ein poröses Substrat aus einem nicht lithiumleitfähigen Material mit einer intrinsisch lithiumleitfähigen LiSICon-Schicht zu versehen. Ein solcher Schichtkörper eignet sich gut als Membran zur Abscheidung von Li⁺ Kationen aus Lithiumhaltigen Wässern. Der Vorteil der Verwendung eines LiSICon-Schichtkörpers anstelle einer monolithischen Membran besteht im Kontext der Elektrodialyse von Lithium darin, dass sich im Schichtkörper die Vorzüge verschiedener LiSICons kombinieren lassen: So kann ein Schichtkörper so konfiguriert werden, dass die mechanische Stabilität der Membran von dem Substrat gewährleistet wird, währenddessen die Selektivität mit einer dünnen LiSICon-Beschichtung erzielt wird. Die dünne Schichtstärke erlaubt die Verwendung von unempfindlichen und preisweiten LLTO ohne die Permeanz der Membran insgesamt stark einzuschränken. Ebenso ist es möglich, auf Phosphat-basiertem LiSICon, welches eine hohe Li-Leitfähigkeit hat, eine dünne Schutzschicht aus LLTO aufzutragen, welche das empfindliche Phosphat gegen Verunreinigungen schützt. Auf diese Weise lassen sich mit einem LiSICon-Schichtkörper in komplexen Einsatzsituationen bessere Lösungen realisieren als mit einer Membran aus nur einem LiSICon-Material.

Die Herstellung des LiSICon-Schichtkörpers gelingt durch die aerosolbasierten Kaltabscheidung.

Bei der aerosolbasierten Kaltabscheidung (auch genannt: Aerosol-Depositions-Methode, ADM) wird ein Substrat im Vakuum mit einem energiereichen Aerosolstrahl beaufschlagt. Dieser enthält ein Trägergas und darin dispergiert ein Pulver. Das Pulver wird auf der Oberfläche des Substrats abgeschieden. So wächst auf dem Substrat eine Schicht auf, in der das Pulvermaterial angereichert ist.

Eine grundlegende Beschreibung des aerosolbasierten Kaltabscheidung findet sich in:
Sozak, M., Nazarenus, T., Exner, J. et al. Room temperature manufacture of dense NaSICON solid electrolyte films for all-solid-state-sodium batteries. J Mater Sci 58, 10108-10119 (2023). https://doi.org/10.1007/s10853-023-08642-w

Hier wird auch erwähnt, dass sich dieses Verfahren auch für das Abscheiden von LAGP und LATP auf diversen Substraten eignet. Eine konkrete Beschreibung eines solchen Verfahrens liefern Sozak et al indes nicht; vielmehr berichten sie in dem zitierten Artikel davon, wie sie ein Substrat aus rostfreiem Stahl bzw. Aluminium mit einem NaSICon-Material beschichtet haben.

Eine weitere Beschreibung der aerosolbasierten Kaltabscheidung findet sich in DE102018003289A1, ein zugehöriger Apparat zur Durchführung des Verfahrens ist in DE102020005738A1 offenbart.

Ein alternativer Prozess der aerosolbasierten Kaltabscheidung wurde beschrieben von Ilka-Verena Luck in ihrem Vortrag NEXT-GENERATION COATING APPLICATIONS BY AEROSOL DEPOSITION auf der Konferenz International Thermal Spray Conference and Exposition am 23.05. 2023 in Quebec, Canada.

Ein weiterer Gegenstand der Erfindung ist ein Schichtkörper, welcher ein Substrat aus Metall, Keramik, Glas, Polymer oder LiSICon und eine Beschichtung aus LAGTSP oder LAGTP oder LAGP oder LLTO aufweist. Ein solcher Schichtkörper kann durch das erfindungsgemäße Verfahren hergestellt werden.

Ein solcher Schichtkörper eignet sich hervorragend als Membran zur Auftrennung von Stoffgemischen, insbesondere zur elektrodialytischen Abscheidung von Lithium aus Lithiumhaltigen Wässern. Diese Verwendung ist ein weiterer Gegenstand der Erfindung.

Bevorzugte Weiterbildungen des erfindungsgemäßen Verfahrens, des erfindungsgemäßen Schichtkörpers und dessen Verwendung sind in den Unteransprüchen niedergelegt.

Insbesondere wurde gefunden, dass sich LATSP Substrate mit Hilfe der aerosolbasierten Kaltabscheidung mit LLTO-, LAGTP- oder LAGP-Pulver besonders gut beschichten lassen, wenn diese Pulver eine mikrokristalline Struktur aufweisen. Diese mikrokristalline Struktur besitzen durch Flammpyrolyse hergestellte anorganische Materialien, wie zum Beispiel Aerosil^{®} von Evonik. Allerdings sind diese aufgrund ihrer Struktur und Partikelgröße für den Prozess der ADM nicht geeignet, da die kleinen und leichten Partikel mit dem Gasstrom mitgerissen werden und einen nicht ausreichend hohe kinetische Energie besitzen, um einen Schichtaufbau auf dem Substrat zu ermöglichen.

Es wurde gefunden, dass diese mikrokristallinen pyrogen hergestellten Verbindungen im ADM-Prozess genutzt werden können, wenn diese nach der erfolgten Herstellung kalziniert und nach der Kalzinierung durch vermahlen auf die für den ADM-Prozess richtige Agglomeratgröße eingestellt werden. Die Kalzinierung der pyrogen hergestellten Partikel erfolgt idealerweise bei einer Temperatur zwischen 500°C und 1000°C, besonders bevorzugt bei 550°C bis zu 800°C, wobei die Behandlung bei dieser Temperatur für eine Zeit zwischen wenigen Minuten bis zu einigen Stunden dauerte. Behandlungszeiten über mehrere Stunden beeinflussen den Prozess nicht negativ, sind aber nicht notwendig. Nach der Kalzinierung erfolgt die Vermahlung auf Mühlen, die geeignet sind, eine gewünschte Partikelgröße mit einem Medianwert X_{50,0} von 1 bis 3 µm zu realisieren, verbunden mit einem X_{99,0} von 10µm (Beispielsweise Sichtmühlen, wie eine Jet Mill, Pulvis von Hosokawa).

In dieser Form mittels ADM aufgebracht erzielt man insbesondere bei der Verwendung Lithium leitfähiger Materialien eine hohe Schichtqualität und eine gute lonenleitfähigkeit, verbunden mit einer guten Schichthaftung.

Auch der lonenübergang von einem Material ins nächste Material erfährt keine erhöhten Widerstände, so dass die Gesamtionenleitung durch eine mehrschichtige Materialkombination sehr gute Leitfähigkeiten aufweist.

Somit ist die Kombination aus ADM-Technologie und den wie beschrieben, maßgeschneiderten keramischen pyrogen hergestellten Partikeln ideal zur Herstellung dünner Lithiumleitfähiger Schichten aus verschiedensten LiSICon-Materialien und Materialkombinationen.

Eine besonders bevorzugte Ausführungsform der Erfindung sieht es vor, dass das erste anorganische Material in einer dotierten Pulverform eingesetzt wird. Die Dotierung des Pulvers erfolgt dabei mit einem Lithiumsalz. Dotierung bedeutet in diesem Kontext, dass die einzelnen Partikel des Pulvers aus dem ersten anorganischen Material (LiSICon) auf ihrer Oberfläche mit dem Lithiumsalz beschichtet oder zumindest gespickt werden. Die innere Aufbau des LiSICons (Kristallstruktur / Stöchiometrie) bleibt davon unberührt. Motivation dieser Dotierung besteht darin, den einzelnen LiSICon-Partikel eine Extraportion Lithium mitzugeben, nämlich in Form des Lithiumsalzes auf der Oberfläche der Partikel. Es hat sich nämlich gezeigt, dass bei Beaufschlagung von LiSICon Material mit hoher Temperatur Lithium aus dem Kristallgitter verloren geht, sodass die Leitfähigkeit für Li⁺-Kationen sinkt. Bei dem ADM Verfahren erhalten die LiSICon Partikel in dem Aerosolstrom eine hohe kinetische Energie. Diese wird in Wärmeenergie umgesetzt, wenn die Partikel auf das Substrat aufschlagen. Dabei erhitzen sich die LiSICon-Partikel, wodurch Li aus dem LiSICon verloren gehen kann. Wenn die Partikel aber nun eine Extraportion Lithium in Gestalt von Lithiumsalz mitbringen, wird das im Kristallgitter des LiSICons fehlende Lithium durch Lithium ersetzt, welches aus dem Lithiumsalz stammt, denn das Lithiumsalz zerfällt ebenfalls unter starker Energieeinwirkung. Im Ergebnis stellt die Dotierung des Pulvers mit dem Lithiumsalz sicher, dass das erste anorganische Material seine intrinsische Leitfähigkeit für Li⁺-Kationen durch den ADM Prozess nicht zu stark einbüßt.

Die folgenden Lithiumsalze eignen sich zum Dotieren des ersten anorganischen Materials: Lithiumnitrat (LiNOs), Lithiumnitrat-Trihydrat (LiNO₃ • 3H₂O), Lithiumhydroxid (LiOH), Lithiumoxid (Li₂O), Lithiumperoxid (Li₂O₂), Lithiumnitrit (LiNOz), Lithiumcarbonat (Li₂CO₃), Lithiumhydrogencarbonat (CHLiOs). Besonders bevorzugt wird Lithiumnitrat zum Dotieren des ersten anorganischen Materials eingesetzt.

Die Dotierung des LiSICon-Pulvers erfolgt nasschemisch: Dafür wird eine Lösung des Lithiumsalzes in einem organischen Lösemittel bereit gestellt. Als organisches Lösemittel eignet sich beispielweise Ethanol. Die Lithiumsalz-Lösung wird sodann mit dem noch undotierten LiSICon-Pulver vermischt, sodass eine Dispersion entsteht. Sodann wird das organische Lösemittel aus der Dispersion entfernt, etwa durch Trocknung. Am besten eignet sich Sprühtrocknung. So wird ein mit Lithiumsalz dotiertes Pulver erhalten.

Diese nasschemische Dotierung lässt sich besonders gut mit der pyrogenen Herstellung des LiSICon-Pulvers kombinieren: Demnach wird das kalzinierte LiSICon-Pulver vor oder nach seiner Vermahlung in der Lithiumsalzlösung dispergiert und sodann getrocknet. Das getrocknete, nunmehr dotierte Pulver kann dann noch erforderlichenfalls vermahlen werden. Auf diese Weise wird das erste anorganische Material erhalten, welches mit dem Aerosolstrom auf das Substrat aufgetragen wird.

Der Teilprozess zur Bereitstellung des ersten anorganischen (LiSICon)-Materials für den Einsatz im ADM Verfahren umfasst demnach vorzugweise die folgenden Schritte:
b1) pyrolytische Herstellung eines Präkursor-Pulvers aus LiSICon-Material;
b2) Kalzinieren des Präkursor-Pulvers;
ba) Bereitstellen eines undotierten Pulvers in Gestalt des kalzinierten Präkursor-Pulvers;
b3) Vermahlen des kalzinierten Präkursor-Pulvers;
bb) Bereitstellen einer Lösung, enthaltend mindestens ein organisches Lösemittel und darin gelöst mindestens ein Lithiumsalz;
bc) Herstellen einer Dispersion durch Dispergieren des undotierten Pulvers in der Lösung;
bd) Entfernen der Lösemittels aus der Dispersion durch Trocknen oder Sprühtrocknen;
be/b4) Erhalt eines dotierten Pulvers als erstes anorganisches Material in Pulverform.

Es ist unerheblich, ob die Vermahlung des kalzinierten Präkursor-Pulvers vor oder nach dessen Dotierung erfolgt.

Die pyrolytische Herstellung von Präkursor-Pulver aus LiSICon-Material ist grundsätzlich bekannt und unter anderem in der WO 2023/078790 A1 offenbart. So beschreibt etwa Example 3 dieser Schrift die pyrolytische Herstellung von LAGTP Pulver. Ein pulverförmiges LiSICon mit der Stöchiometrie LATP wurde in Example 1 der WO 2023/078790 A1 pyrolytisch hergestellt.

Die Kalzinierung ist, wie oben bereits geschildert, erforderlich, um das feine, in der Pyrolyse entstehende LiSICon Material zu agglomerieren. Ohne Kalzinierung hätte das pyrolytisch hergestellte LiSICon-Pulver eine viel zu feine Partikelgröße, um im Wege der Aerosol-basierten Kaltabscheidung erfolgreich verarbeitet werden zu können. Da während der Kalzinierung die Partikel auch zu Agglomeraten anwachsen, die für den angestrebten Zweck zu groß sind, wird das kalzinierte Pulver noch vermahlen und ggf. gesiebt, um die gewünschte Partikelgrößenverteilung final einzustellen. Auf diese Weise wird durch pyrolytische Herstellung des Präkursor-Pulvers aus LiSICon Material, Kalzinierung und Vermahlung des kalzinierten Pulvers und optionaler Siebung und Dotierung ein pulverförmiges LiSICon-Material erhalten, welches folgende Partikelgrößenverteilung aufweist:
Mediangröße X_{50,0} von 1 µm bis 3 µm
Partikelgröße mit Q₀=0.99 (X_{99,0}) von 10 µm.

Beide Größen werden nach ISO 9276-5:2005(E) bestimmt. Die Mediangröße X_{50,0} wird in der Partikeltechnologie oft auch als D₅₀ -Wert bezeichnet.

Ein LiSICon-Pulver mit dieser Partikelgrößenverteilung ist ideal, um damit in einem ADM-Prozess ein Substrat zu beschichten. Auf diese Weise kann basierend auf dem Substrat ein Schichtkörper mit einer oder mehreren Schichten aus LiSICon-Material aufgebaut werden.

Tabelle 1 enthält bevorzugte Ausführungsformen des Schichtkörpers, für dessen Herstellung das Substratmaterial und die anorganischen Materialien entsprechend der Tabellenzeilen ausgewählt sind:

**Tabelle 1: Ausführungsformen**

| Ausführungsform | Substratmaterial | erstes anorganisches Material | zweites anorganisches Material |
|---|---|---|---|
| | erste Schicht | zweite Schicht | dritte Schicht |
| | Substrat | erste Beschichtung | zweite Beschichtung |
| 1 | LATSP | LAGTP | n.a. |
| 2 | LATSP | LAGP | n.a. |
| 3 | LAGTP | LAGP | n.a. |
| 4 | LATSP | LLTO | n.a. |
| 5 | LAGTP | LLTO | n.a. |
| 6* | LATSP | LAGTSP | n.a. |
| 7 | LATSP | LAGTP | LLTO |
| 8 | LAGTP | LAGP | LLTO |
| 9 | M | LATSP | LLTO |
| 10 | M | LAGTP | LLTO |
| 11 | M | LAGP | LLTO |
| 12 | M | LAGP | n.a. |
| 13 | M | LLTO | n.a. |
| 14 | K | LAGTP | LLTO |
| 15 | K | LAGP | LLTO |
| 16 | K | LAGP | n.a. |
| 17 | K | LLTO | n.a. |
| 18 | G | LAGTP | LLTO |
| 19 | G | LAGP | LLTO |
| 20 | G | LAGP | n.a. |
| 21 | G | LLTO | n.a. |
| 22 | P | LAGTP | LLTO |
| 23 | P | LAGP | LLTO |
| 24 | P | LAGP | n.a. |
| 25 | P | LLTO | n.a. |

Die mit einem Asterisk * versehenen Ausführungsformen der Tabelle 1 sind nicht gemäß der Erfindung.

M steht für einen metallischen Werkstoff, K für einen keramischen Werkstoff, G für einen glasartigen Werkstoff und P für einen Werkstoff aus einem organischen Polymer. Die Akronyme stehen für LiSICon-Materialien mit der entsprechenden Stöchiometrie. n.a. steht für nicht anwendbar, was in dieser Tabelle bedeutet, dass bei diesem Ausführungsbeispiel keine dritte Schicht vorliegt.

Metallische Werkstoffe umfassen reine Metalle wie Fe, Cr, Ni, Cu, Al, Mg oder Legierungen wie Stahl, Buntmetall oder Leichtmetall.

Keramische Werkstoffe umfassen alle Arten von Oxid, Carbid und Nitrid-Keramiken, insbesondere umfasst dies Zirkonoxid, Aluminiumoxid, Titandioxid, Siliziumdioxid, Siliziumcarbid und Siliziumnitrid.

Glasartige Werkstoffe können alle Arten von Gläsern sein, insbesondere Gläser, die bei niedrigen und hohen pH-Werten eine gute Beständigkeit aufweisen. Bevorzugt handelt es sich bei den Gläsern um anorganische Gläser, insbesondere um Silicat oder Borat-Gläser.

LiSICon-Materialien sind keramische Werkstoffe. Manche LiSICon-Materialien liegen in einem glasartigen Zustand vor, sodass es dabei sowohl um einen keramischen Werkstoff, als auch um einen glasartigen Werkstoff handelt.

Werkstoffe aus organischen Polymeren können aus Polyolefinen, wie Polypropylen (PP) oder Polyethylen (PE) bestehen. Sie könne auch aus Polyimiden (PI), aus Polyamiden (PA), Polyestern (PES) und Polyurethanen (PU), Polyvinylchloriden (PVC) und Polyacrylaten, aber auch aus Polyphenylensulfid, Polyetherimid, Polysulfon, Polyethersulfon und anderen sogenannten Hochleistungspolymeren bestehen. Ebenso sind auch Co-Polymere verwendbar, wie beispielsweise Copolymere aus Acrylnitril, Butadien und Styrol, wobei die Zusammensetzung in weiten Bereichen variieren können.

Die in Tabelle 1 dargestellten Ausführungsformen beruhen also auf geordneten Paaren, bei denen der linke Eintrag für das erste anorganische Material und der rechte Eintrag für das zweite anorganische Material steht.
(LATSP, LAGTP)
(LATSP, LAGP)
(LAGTP, LAGP)
(LATSP, LLTO)
(LAGTP, LLTO)
(M, LATSP)
(M, LAGTP)
(M, LAGP)
(M, LLTO)
(K, LAGTP)
(K, LAGP)
(K, LLTO)
(G, LAGTP)
(G, LAGP)
(G, LLTO)
(P, LAGTP)
(P, LAGP)
(P, LLTO)

Weitere Ausführungsformen beruhen auf einer zusätzlichen Schicht aus LLTO.

Allen Ausführungsformen ist gemeinsam, dass das LiSICon-Material mit der höchsten Beständigkeit gegenüber den Alkali- und Erdalkali-Ionen in der jeweiligen Kombination als letzte Schicht aufgetragen ist.

Die besonders bevorzugten Ausführungsformen beruhen auf drei geordneten Paaren, bei denen der linke Eintrag für das erste anorganische Material und der rechte Eintrag für das zweite anorganische Material steht.
(LATSP, LAGTP);
(LATSP, LAGP);
(LATSP, LLTO);

Weitere besonders bevorzugte Ausführungsformen beruhen auf einer zusätzlichen Beschichtung aus LLTO, sodass ein dreischichtiger Aufbau entsteht.

Idealerweise liegen die Substratmaterialien in einer porösen Form vor. Porös bedeutet, dass das Substrat Poren aufweist. Die Poren sollten insbesondere von außen zugänglich und weiter vorzugsweise untereinander verbunden sein. Das Substrat ist also vorzugsweise offenporig. Ein Substrat in textiler Form, insbesondere ein textiles Flächengebilde ist porös in diesem Sinne, denn zwischen den Fasern des Textils bilden sich Poren aus. Textile Flächengebilde sind unter anderem Gewebe, Gewirke, Gestricke, Gelege, Filze oder Vliese. Neben einer textilen Form kommen auch Substrate in Betracht, die ihre Porosität aus einer Kornstruktur erhalten, wie etwa Sinterkörper. Sinterkörper sind aus Körnern aufgebaut, die an ihren Korngrenzen teilweise verschmolzen sind. Da die Verschmelzung nur teilweise ist, sind die Korngrenzen eines Sinterkörpers noch erkennbar. Zwischen den Korngrenzen bildet ein Sinterkörper Poren aus.

Wie bereits geschildert, kann das Substrat aus einem Metall, aus einer Keramik, aus einem organischen Polymer oder aus einem glasartigen Werkstoff bestehen. In der Klasse der metallischen Substrate sind insbesondere poröse Sintermetalle oder Metallschäume oder Streckmetalle oder Lochbleche oder Metallvliese oder feine Metallgewebe (Gaze) geeignet. Organische Substratmaterialien liegen vorzugsweise in textiler Form, also als textiles Flächengebilde mit organischen Fasern vor, insbesondere als Vlies aus Fasern, welche aus dem gewünschten Substratmaterial bestehen. Alternativ könne organische Substratmaterialien als Folie eingesetzt werden. Keramische Materialien werden vorzugsweise als flache Sinterkeramik eingesetzt. Glasartige Werkstoffe können entweder als Flachglas gegossen sein oder als Glasfritte durch Verschmelzen von Glaskörnern. Glasfritten sind vorteilhafterweise porös. LiSICon-Materialen erhalten in der Regel durch Sol-Gel-Technologie ihre Formgebung oder auch durch Sinterung von entsprechendem LiSICon-Pulvern. Da sich durch die Sinterung von LiSICon-Pulvern poröse Substrate aus LiSICon-Material herstellen lassen, ist dieser Weg bevorzugt. Vorzugweise wird LiSICon-Pulver unter mechanischem Druck und unter Einwirkung von elektrischem Strom gesintert (Spark Plasma Sintering). Die an dieser Stelle beschrieben Prozesse sind Stand der Technik. Die auf diese Weise erhaltenen Substrate sind kommerziell erhältlich. Insbesondere lassen sich kommerziell erhältliche organische oder anorganische Ultrafiltrationsmembranen, Glasfritten oder Sintermetallfritten als poröses Substrat verwenden.

Es kann auch vorteilhaft sein, als Substrat einen Verbund einzusetzen, der keramische und organische Werkstoffe kombiniert. Als Beispiel dafür sind etwa solche Verbundkörper zu nennen, wie sie aus EP 3669974 B1 bekannt geworden sind. Wird ein solcher Verbundkörper als Substrat eingesetzt, enthält das Substrat entsprechend mehrere Substratmaterialien.

Die mittlere Porenweite des Substrats sollte kleiner als 10 µm, insbesondere kleiner als 1 µm und ganz besonders bevorzugt kleiner 0.2 µm sein. Dies ermöglicht eine gute Tränkung des Substrats mit einem flüssigen Elektrolyt, insbesondere mit einem wässrigen Katholyt einer Elektrodialysezelle. Dies wird unten noch eingehender beschrieben. Außerdem ist es vorteilhaft, wenn die mittlere Porenweite des Substrats kleiner ist als die Mediangröße X_{50,0} des Pulvers aus dem ersten anorganischen Material (LiSICon), welches auf das Substrat aufgetragen wird. Dies ermöglicht es nämlich eine geschlossene Beschichtung aus LiSICon-Material auf dem porösen Substrat aufzutragen, sodass der Schichtkörper insgesamt fluiddicht wird. Sofern das Pulver feiner ist als die Poren, ist nicht ausschließen, dass einige Poren trotzt Beschichtung mit dem ADM-Verfahren unverschlossen bleiben. Der Schichtkörper wäre dann für Fluide durchlässig und ließe sich dann nicht mehr als hochselektive Membran einsetzen. Deswegen ist es bevorzugt, wenn die Partikelgrößenverteilung des Pulvers aus dem ersten anorganischen (LiSICon-)Material so eingestellt ist, dass dessen Mediangröße X_{50,0} größer ist als die mittlere Porenweite des porösen Substrats. Die Partikelgrößenverteilung des Pulvers wird einfachstenfalls durch Vermahlen des ersten anorganischen Materials eingestellt. Das Vermahlen kann in mehreren Stufen erfolgen. Erforderlichenfalls sind vor bzw. nach den einzelnen Mahlstufen Sieb- und/oder Sichtungschritte vorzusehen. Vorzugsweise werden diese Schritte in einer Kombination aus einer Mühle und einem Windsichter ausgeführt. In den Sieb- bzw. Sichtungsschritten wird das Überkorn abgetrennt, so dass es in den Mahlprozess zurückgegeben werden kann und/oder das Unterkorn entfernt, welches der gewünschten Partikelgrößenverteilung nicht entspricht.

Die Bestimmung der mittleren Porenweite erfolgt mittels Gasfluss Porometrie wie nachfolgend beschrieben mit einem Porolux 1000 (Porometer, Eke, Belgien). Dazu wird aus dem zu analysierenden Material eine kreisrunde Probe mit Durchmesser 25 mm ausgestanzt, bei 100 °C für 1 Stunde im Trockenschrank getrocknet um Feuchtigkeit aus den Poren zu entfernen, und anschließend unverzüglich in der Benetzungsflüssigkeit Porefil^{®} eingelegt, damit sämtliche vorhandenen Poren mit dieser Flüssigkeit gefüllt sind. Anschließend wird die Probe durch kurzzeitiges Anlegen von Vakuum (150 mbar bzw. 15 kPa) im Exsikkator entgast, um sicherzustellen, dass alle Poren mit Porefil^{®} gefüllt sind. Die entgaste Probe wird in den Probenhalter des Messgerätes eingelegt und der Probenhalter verschraubt.

Die Bestimmung der Porenradienverteilung beruht auf dem Messprinzip der Kapillarfluss-Porometrie. Die mit der Benetzungsflüssigkeit getränkte und entgaste Probe wird in der Messzelle mit einem schrittweise ansteigendem Inertgas-Druck (Stickstoff) beaufschlagt und die dem anliegenden Druck entsprechenden Porendurchmesser werden durch den Gasdruck entleert. Dabei wird die Flussrate des Gases bei ansteigenden Drücken aufgenommen. In den durchgängigen Poren findet ein Austausch der Benetzungsflüssigkeit mit Stickstoff statt. Dies erfolgt solange, bis der relevante Porenbereich erfasst wurde, d.h. bis auch die kleinsten im Messbereich vorhandenen Poren von Flüssigkeit befreit sind. Anschließend wird der Druck in der Messzelle wieder abgesenkt und die Messung an der nun trockenen Probe wiederholt. Aus der Differenz der Nasskurve und der Trockenkurve wird die Porenweitenverteilung berechnet. Die Porometrie-Messungen führen zur Kenntnis der größten vorhandenen Porenradien (sogenannter "bubble point"), sowie den häufigsten und den kleinsten Porendurchmessern.

Die Verwendung von porösen Substratmaterialen ist insbesondere dann vorteilhaft, wenn der Schichtkörper als Membran in einer elektrodialytischen Abtrennung von Lithium aus Lithiumhaltigen Wässern genutzt werden soll. In einer solchen Anwendung wird der als Membran genutzte Schichtkörper nämlich so in eine elektrochemische Zelle eingebaut, dass die Schicht mit dem LiSICon-Material mit dem Lithiumhaltigen Wasser in Kontakt steht. Das Substrat ist entsprechend davon abgewandt. Das Substrat steht vielmehr mit dem Katholyt der elektrochemischen Zelle in Kontakt, in dem sich das abgetrennte Lithium während der Elektrodialyse anreichert (Das Lithium liegt nämlich im Lithiumhaltigen Wasser gelöst als Li⁺ Kation vor, was entsprechend des in der elektrochemischen Zelle herrschenden, elektrischen Potentials durch das LiSICon-Material hindurch in Richtung der Kathode wandert. Die Li⁺ Kationen reichern sich folglich im Zuge der Elektrodialyse im Katholyt der Zelle an. Bei dem Katholyt handelt es sich meist um eine wässrige Lösung. Damit der Katholyt die Li⁺ Kationen aufnehmen kann, muss er in Kontakt stehen mit dem LiSICon-Material, welches dem Katholyt die Lithiumkationen anreicht. Im Interesse einer hohen Permeanz der Membran für Lithium muss eine besonders große Kontaktfläche zwischen LiSICon-Material und Katholyt gewährleistet sein. Weil der Katholyt die Poren des Substrats infiltriert, erhöht die Porosität des Substrats die Kontaktfläche zwischen LiSICon Material und Katholyt und damit auch die Permeanz der Membran. Die erhöhte Permeanz wirkt sich wiederum positiv auf die Effizienz der Elektrodialyse aus.

Sofern es sich bei dem Substrat um eine LiSICon-Material handelt, ist die Porosität des Substrats nicht zwingend erforderlich, um die Anwendung des Schichtkörpers als Membran in der elektrodialytischen Abtrennung von Lithium aus Lithiumhaltigen Wässern zu ermöglichen. Sie ist lediglich wünschenswert im Interesse der Effizienzsteigerung. Sofern es sich aber bei dem Substrat um ein Material handelt, welches keine Leitfähigkeit für Lithiumkationen besitzt, muss dieses Material zwingend porös sein, weil ansonsten die Li⁺ Kationen nicht in den Katholyt gelangen. Im Ergebnis darf das Substrat in der Elektrodialyse von Lithium nicht dicht für Lithium sein: Es wird durchlässig beispielweise durch seine intrinsischen Leitfähigkeit als LiSICon-Material oder durch seine poröse Struktur, welche mit Katholyt getränkt werden kann. Selbstverständlich können beide Eigenschaften auch kombiniert von dem Substrat erfüllt sein.

Sofern der Schichtkörper einen anderen Einsatzzweck hat als die Funktion einer Membran in der elektrodialytischen Lithiumabtrennung, kann das Substrat durchaus auch lithiumdicht und insbesondere auch frei von Poren sein.

Im Kontext der elektrodialytischen Abtrennung von Lithium aus lithiumhaltigen Wässern, die neben den Lithiumkationen noch kationische Verunreinigungen enthalten wie insbesondere Kationen der Elemente aus B, Na, Mg, Al, Si, K, Ca, Mn, Fe, Co, Ni, Cu, C, empfiehlt es sich, einen dreischichtigen Schichtköper als Membran zu verwenden, der wie folgt aufgebaut ist: Poröses Substrat, erste Beschichtung aus einem ersten LiSICon-Material und auf der ersten Beschichtung noch eine zweite Beschichtung aus einem zweiten LiSICon-Material, wobei das zweite LiSICon-Material eine geringe Empfindlichkeit gegen die kationischen Verunreinigungen aufweist als das erste LiSICon-Material. Da im Betrieb der Membran die zweite Beschichtung zu den kationischen Verunreinigungen exponiert ist, schützt die zweite Beschichtung aus dem unempfindlicheren Material die erste Beschichtung. Das in der ersten Beschichtung angereicherte erste LiSICon-Material kann eine höhere spezifische Li-Leitfähigkeit aufweisen als das in der zweiten Beschichtung angereicherte zweite LiSICon-Material. Dadurch wird die Membran insgesamt selektiver. Ebenso kann das zweite LiSICon-Material preiswerter sein als das erste LiSICon-Material, damit die Membran insgesamt billiger wird. Es ist auch denkbar, die Schichtstärken s der jeweiligen LiSICon-Schichten unterschiedlich zu wählen: Die Stärke *s*₁ der ersten Schicht enthaltend das erste anorganische Material kann größer sein als die Stärke *s*₂ der zweiten Schicht enthaltend das zweite anorganische Material. Dies ist dann sinnvoll, wenn das erste anorganische Material teurer ist als das zweite. Selbstverständlich kann es in anderen Situationen sinnvoll sein, *s*₂ größer als *s*₁ zu wählen.

Aus diesen Gründen weist ein in der Li-Abtrennung als Membran genutzter, dreischichtiger Schichtkörper vorzugsweise eine zweite Beschichtung aus LLTO auf. Die erste Beschichtung kann wahlweise aus LAGTP, LAGP oder LATSP bestehen. Substrat können alle hier diskutierten Materialien verwendet werden, solange sie in poröser Form vorliegen. Die entsprechenden Materialkombinationen sind in Tabelle 1 niedergelegt.

Sofern LLTO als Beschichtungsmaterial verwendet wird, bietet es sich optional an, dotiertes LLTO zu verwenden. Es ist nämlich bekannt, dass sich die Li-Leitfähigkeit von LLTO durch Dotierung mit einem Dotierelement steigern lässt. Die folgenden Elementen kommen dafür die Dotierung des LLTO in Betracht: Ag, Al, Zr, Nd, Sr, Ta, Y, Ge, Nb. Ein Verfahren zur Dotierung von LLTO mit Aluminium, genauer gesagt mit Al³⁺, wurde vorgestellt von Huang Yi et al:
Huang Y., He L., Zhu X.: Low temperature synthesis of Li0.33La0.55TiO3 solid electrolyte with Al3+ doping by a modified Pechini method. (2022) lonics, 28 (4), pp. 1739 - 1751 DOI: 10.1007/s11581-021-04422-1

Anders als die Dotierung der Partikel mit Lithiumsalz handelt es sich bei der Dotierung von LLTO mit den Dotierelementen Ag, Al, Zr, Nd, Sr, Ta, Y, Ge, Nb um eine Dotierung auf Kristallebene.

Ein anderes dotiertes LiSICon, welches im Rahmen der Erfindung als erstes anorganisches Material zur Beschichtung eingesetzt werden kann, ist dotiertes LLZO:

Li₇La₃ (Zr, D)₂O₁₂ (LLZO)

Die Dotiersubstanz D von LLZO ist wahlweise Hf, Ce oder Ru. Ein Verfahren zur Herstellung von entsprechend dotiertem LLZO beschrieben Lee, Han Uk et al.:
Lee H.U., Han S., Lee D.G., Ko H., Lee J., Im W.B., Song T., Choi J., Cho S.B.: Isovalent multi-component doping strategy for stabilizing cubic-Li7La3Zr2O12 with excellent Li mobility. Chemical Engineering Journal, 471, art. no. 144552. DOI: 10.1016/j.cej.2023.144552

Anders als die Dotierung der Partikel mit Lithiumsalz handelt es sich bei der Dotierung von LLZO mit den Dotiersubstanzen Hf, Ce oder Ru um eine Dotierung auf Kristallebene.

Ein weiterer Vorteil des aerosolbasierten Kaltabscheidung ist darin zu sehen, dass dieses Verfahren den Aufbau von sehr geringen Schichtstärken erlaubt. Vorzugsweise ist die Schicht, in der das erste anorganische Material angereichert ist, kleiner als 10 µm stark, ganz besonders bevorzugt kleiner als 1 µm. Diese dünnen Schichten aus LiSICon-Material ermöglichen eine besonders hohe Permeanz, wenn der Schichtkörper als Membran eingesetzt wird. Bisher war es nicht möglich, LiSICon-Membranen mit einer Stärke unter 10µm herzustellen. Sofern der Schichtkörper zwei Schichten aus LiSICon-Material aufweist, können beide Schichten eine Stärke in diesem Größenbereich aufweisen.

## Patentansprüche

1. Verfahren zur Herstellung eines Schichtkörpers mit den folgenden, nicht chronologischen Schritten:
a) Bereitstellen eines Substrats enthaltend mindestens ein Substratmaterial;
b) Bereitstellen eines ersten anorganischen Materials in Pulverform;
c) Bereitstellen eines Trägergases;
d) Dispergieren des ersten anorganischen Materials in dem Trägergas, sodass ein Aerosolstrom erhalten wird,
e) Platzieren des Substrats in einem evakuierten Raum, in welchem ein Absolutdruck von 0.1 kPa bis 1 kPa und eine Temperatur von 15°C bis 25°C herrschen;
f) Beaufschlagen des in dem evakuierten Raum platzierten Substrats mit dem Aerosolstrom, sodass zumindest eine Schicht enthaltend das erste anorganische Material auf dem Substrat abgeschieden wird;
g) Erhalt eines Schichtkörpers umfassend das Substrat und mindestens die vorerwähnte Schicht, in welcher das erste anorganische Material angereichert ist, wobei die vorerwähnte Schicht auf dem Substrat abgeschieden ist;
**dadurch gekennzeichnet,**
**dass** das Substratmaterial ausgewählt ist aus der Gruppe bestehend aus den folgenden Materialien:
• metallischer Werkstoff M;
• keramischer Werkstoff K;
• glasartiger Werkstoff G;
• polymerer Werkstoff P;
• LiSICon mit der Stöchiometrie LATSP
Li_{1+x+y}AlₓTi₂₋ₓSi_{y}P_{3-y}O₁₂ (LATSP)
worin in LATSP gilt: 0.1≤x≤0.3 und 0.2≤y≤0.4;
• LiSICon mit der Stöchiometrie LAGTP
Li_{1.4}Al_{0.4}(Ge₁₋ₓTiₓ)_{1.6} (PO₄)₃ (LAGTP)
worin in LAGTP gilt: 0≤x≤1
und **dass** das erste anorganische Material ausgewählt ist aus der Gruppe bestehend aus den folgenden Materialien:
∘ LiSICon mit der Stöchiometrie LAGTP
Li_{1.4}Al_{0.4}(Ge₁₋ₓTiₓ)_{1.6} (PO₄)₃ (LAGTP)
worin in LAGTP gilt: 0≤x≤1
∘ LiSICon mit der Stöchiometrie LAGP
Li₁₊ₓAlₓGe₂₋ₓ (PO₄)₃ (LAGP)
worin in LAGP gilt: x=0 oder x=0.2 oder x=0.4.
∘ LiSICon mit der Stöchiometrie LATSP
Li_{1+x+y}AlₓTi₂₋ₓSi_{y}P_{3-y}O₁₂ (LATSP)
worin in LATSP gilt: 0.1≤x≤0.3 und 0.2≤y≤0.4;
∘ LiSICon mit der Stöchiometrie LLTO
Li₃ₓLa_{(2/3)-x□(1/3)-2x}TiO₃ (LLTO)
worin in LLTO gilt: 0≤x≤0.16 und wobei das LLTO optional dotiert sein kann mit mindestens einem Dotierelement, welches ausgewählt ist aus der Gruppe bestehend aus den folgenden Dotierelementen: Ag, Al, Zr, Nd, Sr, Ta, Y, Ge, Nb;
∘ LiSICon mit der Stöchiometrie LLZO
Li₇La₃ (Zr, D)₂O₁₂ (LLZO)
worin in LLZO die Dotiersubstanz D ausgewählt aus der Gruppe bestehend aus den folgenden Dotiersubstanzen: Hf, Ce, Ru.

2. Verfahren nach Anspruch 1, wobei das Trägergas Sauerstoff enthält und mit einem Druck von 5 kPa bis 50 kPa bereit gestellt wird.

3. Verfahren nach Anspruch 1 oder 2 **gekennzeichnet durch** eine Relativbewegung zwischen Aerosolstrom und Substrat, wobei sich die Relativbewegung in der Ebene des Substrats erstreckt und wobei die Geschwindigkeit der Relativbewegung zwischen 1mm/s und 10 mm/s beträgt.

4. Verfahren nach Anspruch 1, 2 oder 3, wobei das Substratmaterial und das erste anorganische Material ein geordnetes Paar bilden welches ausgewählt ist aus der Gruppe bestehend aus den folgenden geordneten Paaren:
(LATSP, LAGTP)
(LATSP, LAGP)
(LAGTP, LAGP)
(LATSP, LLTO)
(LAGTP, LLTO)
(M, LATSP)
(M, LAGTP)
(M, LAGP)
(M, LLTO)
(K, LAGTP)
(K, LAGP)
(K, LLTO)
(G, LAGTP)
(G, LAGP)
(G, LLTO)
(P, LAGTP)
(P, LAGP)
(P, LLTO)
wobei der jeweils linke Eintrag der geordneten Paare für das Substratmaterial steht und wobei der jeweils rechte Eintrag der geordneten Paare für das erste anorganische Material steht.

5. Verfahren nach Anspruch 1, 2 oder 3, wobei das Substratmaterial und das erste anorganische Material ein geordnetes Paar bilden welches ausgewählt ist aus der Gruppe bestehend aus den folgenden geordneten Paaren:
(LATSP, LAGTP);
(LATSP, LAGP);
(LATSP, LLTO);
wobei der jeweils linke Eintrag der geordneten Paare für das Substratmaterial steht und wobei der jeweils rechte Eintrag der geordneten Paare für das erste anorganische Material steht.

6. Verfahren nach einem der Ansprüche 1 bis 5, **dadurch gekennzeichnet, dass** das Substrat porös ist.

7. Verfahren nach Anspruch 6, **dadurch gekennzeichnet, dass** das Substrat eine nach dem in der Beschreibung definierten Verfahrenen bestimmte, mittlere Porenweite d aufweist, wobei die mittlere Porenweite d zwischen 0 und 10 µm oder zwischen 0 und 1 µm oder zwischen 0 und 0.2 µm liegt.

8. Verfahren nach einem der Ansprüche 1 bis 7, **dadurch gekennzeichnet, dass** das erste anorganische Material mit der folgenden Partikelgrößenverteilung bereitgestellt wird:
Mediangröße X_{50,0} von 1 µm bis 3 µm
Partikelgröße mit Q₀=0.99 (*X*_{99,0}) von 10 µm.
beide Größen bestimmt nach ISO 9276-5:2005(E).

9. Verfahren nach den Ansprüchen 7 und 8, **dadurch gekennzeichnet, dass** die mittlere Porenweite d kleiner ist als die Mediangröße X_{50,0}.

10. Verfahren nach einem der Ansprüche 1 bis 9, bei dem der Schritt b) Bereitstellen eines ersten anorganischen Materials in Pulverform; zumindest die folgenden Teilschritte umfasst:
b1) pyrolytische Herstellung eines Präkursor-Pulvers;
b2) Kalzinieren des Präkursor-Pulvers;
b3) Vermahlen des kalzinierten Präkursor-Pulvers;
b4) Erhalt des ersten anorganischen Materials in Pulverform.

11. Verfahren nach Anspruch 10, **dadurch gekennzeichnet, dass** das Kalzinieren bei einer Temperatur zwischen 500°C und 1000°C oder bei einer Temperatur zwischen 550°C und 800°C erfolgt, und dass das Kalzinieren über einen Zeitraum von 1 Minute bis 300 Minuten erfolgt.

12. Verfahren nach einem der vorhergehenden Ansprüche 1 bis 11, **dadurch gekennzeichnet, dass** das erste anorganische Material mit mindestens einem Lithiumsalz dotiert ist, wobei das Lithiumsalz ausgewählt ist aus der Gruppe bestehend aus den folgenden Lithiumsalzen: Lithiumnitrat, Lithiumnitrat-Trihydrat, Lithiumhydroxid, Lithiumoxid, Lithiumperoxid, Lithiumnitrit, Lithiumcarbonat, Lithiumhydrogencarbonat.

13. Verfahren nach Anspruch 12, **dadurch gekennzeichnet, dass** der Schritt b) Bereitstellen eines ersten anorganischen Materials in Pulverform; die folgenden Teilschritte umfasst:
ba) Bereitstellen eines undotierten Pulvers;
bb) Bereitstellen einer Lösung, enthaltend mindestens ein organisches Lösemittel und darin gelöst mindestens das Lithiumsalz;
bc) Herstellen einer Dispersion durch Dispergieren des undotierten Pulvers in der Lösung;
bd) Entfernen des Lösemittels aus der Dispersion durch Trocknen oder durch Sprühtrocknen;
be) Erhalt eines dotierten Pulvers.

14. Verfahren zumindest nach den Ansprüchen 11 und 13, wobei es sich bei dem undotierten Pulver um kalziniertes Präkursor-Pulver handelt und wobei es sich bei dem dotierten Pulver um das erste anorganische Material in Pulverform handelt.

15. Verfahren nach einem der Ansprüche 1 bis 14, ferner umfassend die zusätzlichen Schritte:
h) Bereitstellen eines zweiten anorganischen Materials in Pulverform;
i) Dispergieren des zweiten anorganischen Materials in dem Trägergas, sodass ein weiterer Aerosolstrom erhalten wird,
j) Beaufschlagen des in dem evakuierten Raum platzierten, bereits beschichteten Substrats mit dem weiteren Aerosolstrom, sodass zumindest eine weitere Schicht enthaltend das zweite anorganische Material auf der vorerwähnten Schicht enthaltend das erste anorganische Material abgeschieden wird;
k) Erhalt eines Schichtkörpers umfassend das Substrat, die vorerwähnte Schicht, in welcher das erste anorganische Material angereichert ist, und die weitere Schicht, in der das zweite anorganische Material angereichert ist, wobei die weitere Schicht auf der vorerwähnten Schicht abgeschieden ist.

16. Schichtkörper mit einem Substrat, welches mindestens ein Substratmaterial enthält und mit mindestens einer auf das Substrat aufgebrachten Schicht, in welcher ein erstes anorganisches Material angereichert ist,
**dadurch gekennzeichnet,**
**dass** das Substratmaterial ausgewählt ist aus der Gruppe bestehend aus den folgenden Materialien:
• metallischer Werkstoff M;
• keramischer Werkstoff K;
• glasartiger Werkstoff G;
• polymerer Werkstoff P;
• LiSICon mit der Stöchiometrie LATSP
Li_{1+x+y}AlₓTi₂₋ₓSi_{y}P_{3-y}O₁₂ (LATSP)
worin in LATSP gilt: 0.1≤x≤0.3 und 0.2≤y≤0.4;
• LiSICon mit der Stöchiometrie LAGTP
Li_{1.4}Al_{0.4}(Ge₁₋ₓTiₓ)_{1.6} (PO₄)₃ (LAGTP)
worin in LAGTP gilt: 0≤x≤1
und **dass** das erste anorganische Material ausgewählt ist aus der Gruppe bestehend aus den folgenden Materialien:
∘ LiSICon mit der Stöchiometrie LAGTP
Li_{1.4}Al_{0.4}(Ge₁₋ₓTiₓ)_{1.6} (PO₄)₃ (LAGTP)
worin in LAGTP gilt: 0≤x≤1
∘ LiSICon mit der Stöchiometrie LAGP
Li₁₊ₓAlₓGe₂₋ₓ (PO₄)₃ (LAGP)
worin in LAGP gilt: x=0 oder x=0.2 oder x=0.4.
∘ LiSICon mit der Stöchiometrie LATSP
Li_{1+x+y}AlₓTi₂₋ₓSi_{y}P_{3-y}O₁₂ (LATSP)
worin in LATSP gilt: 0.1≤x≤0.3 und 0.2≤y≤0.4;
∘ LiSICon mit der Stöchiometrie LLTO
Li₃ₓLa_{(2/3)-x□(1/3)-2x}TiO₃ (LLTO)
worin in LLTO gilt: 0≤x≤0.16 und wobei das LLTO optional dotiert sein kann mit mindestens einem Dotierelement, welches ausgewählt ist aus der Gruppe bestehend aus den folgenden Dotierelementen: Ag, Al, Zr, Nd, Sr, Ta, Y, Ge, Nb;
∘ LiSICon mit der Stöchiometrie LLZO
Li₇La₃ (Zr, D)₂O₁₂ (LLZO)
worin in LLZO die Dotiersubstanz D ausgewählt aus der Gruppe bestehend aus den folgenden Dotiersubstanzen: Hf, Ce, Ru.

17. Schichtkörper nach Anspruch 16, wobei das Substratmaterial und das erste anorganische Material ein geordnetes Paar bilden welches ausgewählt ist aus der Gruppe bestehend aus den folgenden geordneten Paaren:
(LATSP, LAGTP)
(LATSP, LAGP)
(LAGTP, LAGP)
(LATSP, LLTO)
(LAGTP, LLTO)
(M, LATSP)
(M, LAGTP)
(M, LAGP)
(M, LLTO)
(K, LAGTP)
(K, LAGP)
(K, LLTO)
(G, LAGTP)
(G, LAGP)
(G, LLTO)
(P, LAGTP)
(P, LAGP)
(P, LLTO)
wobei der jeweils linke Eintrag der geordneten Paare für das Substratmaterial steht und wobei der jeweils rechte Eintrag der geordneten Paare für das erste anorganische Material steht.

18. Schichtkörper nach Anspruch 17, **gekennzeichnet durch** eine weitere Schicht, in welcher ein zweites anorganisches Material angereichert ist, wobei die weitere Schicht auf die vorerwähnte Schicht aufgebracht ist.

19. Schichtkörper nach einem der Ansprüche 16 bis 18, erhältlich durch ein Verfahren nach einem der Ansprüche 1 bis 15.

20. Schichtkörper nach einem der Ansprüche 16 bis 19, **gekennzeichnet durch** eine flache Gestalt und/oder **durch** ein poröses Substrat.

21. Schichtkörper nach einem der Ansprüche 16 bis 20, wobei die Schicht, in der das erste anorganische Material angereichert ist, und/oder die Schicht, in der das zweite anorganische Material angereichert ist, eine Schichtstärke s aufweist, die größer ist als 0 µm, **dadurch gekennzeichnet, dass** Schichtstärke s kleiner ist als 10 µm oder kleiner ist als 1 µm.

22. Verwendung eines Schichtkörpers nach einem der Ansprüche 16 bis 21 als Membran zur elektrodialytischen Abtrennung von Lithium aus lithiumhaltigen Wässern.

23. Verwendung nach Anspruch 22, **gekennzeichnet durch** die Anwesenheit von kationischen Verunreinigungen in den lithiumhaltigen Wässern, wobei es sich bei den kationischen Verunreinigungen um Kationen von Elementen handelt, die ausgewählt sind aus der Gruppe bestehend aus B, Na, Mg, Al, Si, K, Ca, Mn, Fe, Co, Ni, Cu, C

24. Verwendung nach Anspruch 22 oder 23, **gekennzeichnet durch** die Anwesenheit von anionischen Verunreinigungen in den lithiumhaltigen Wässern, wobei es sich bei den anionischen Verunreinigungen um Anionen handelt, die ausgewählt sind aus der Gruppe bestehend aus Sulfat, Hydrogensulfat, Carbonat, Hydrogencarbonat, Hydroxid, Chlorid, Fluorid.
